# DEMANDE DE BREVET EUROPEEN

(11) **EP 4 092 730 A2**
(43) Date de publication de la demande: **23.11.2022**
(21) Numéro de dépôt: 22171818.2
(22) Date de dépôt: 05.05.2022
(51) Int. Cl.: H01L 23/485, H01L 21/60, H01L 23/31, H01L 21/784

(54) **FABRICATION DE PUCES ÉLECTRONIQUES**

(30) Priorité: 18.05.2021 FR 2105176
(71) Demandeur: STMicroelectronics (Tours) SAS, 37100 Tours (FR)
(72) Inventeur: ORY, Olivier, 37100 TOURS (FR); DE CRUZ, Michael, 37380 MONNAIE (FR)
(74) Mandataire: Cabinet Beaumont

(57) **Abrégé**

La présente description concerne une puce électronique (1) comportant un substrat semi-conducteur (11) portant au moins un contact métallique (31) s'étendant, dans l'épaisseur du substrat, le long d'au moins un flanc de la puce.

## Description

### Domaine technique

La présente description concerne la fabrication de puces électroniques. Elle vise plus particulièrement la fabrication de puces dites à montage en surface, c'est-à-dire comportant, du côté d'au moins une face, une ou plusieurs métallisations de connexion destinées à être brasées à des plages de connexion correspondantes d'un dispositif externe, par exemple une carte de circuit imprimé ou une autre puce.

### Technique antérieure

Dans certaines applications, il existe un besoin pour des puces à montage en surface dans lesquelles les métallisations de connexion destinées à être brasées à un dispositif externe s'étendent jusqu'aux flancs des puces. On parle de puces à flancs mouillables (en anglais "wettable flank"). Lors du montage de la puce dans son environnement (par exemple, sur une carte de circuit imprimé), les métallisations de connexion sont soudées ou brasées à des pistes ou éléments métalliques correspondants coté circuit imprimé. Une partie du matériau de brasage remonte alors sur les flancs des puces, ce qui permet de mettre en oeuvre une inspection visuelle de la qualité des connexions. Ce besoin existe par exemple dans le domaine automobile ou le domaine médical et, plus généralement, dans les domaines où l'on souhaite garantir la fiabilité des connexions électriques, une fois les circuits montés dans leur environnement.

Il serait souhaitable d'améliorer au moins en partie certains aspects des procédés connus de fabrication de puces électroniques à flancs mouillables.

### Résumé de l'invention

Il existe un besoin d'amélioration des puces électroniques connues et de leur procédé de fabrication.

Un mode de réalisation pallie tout ou partie des inconvénients des puces électroniques connues et de leur procédé de fabrication.

Un mode de réalisation prévoit une puce électronique comportant un substrat semi-conducteur portant au moins un contact métallique s'étendant, dans l'épaisseur du substrat, le long d'au moins un flanc de la puce.

Un autre mode de réalisation prévoit un procédé de fabrication d'une puce électronique comportant au moins une étape de formation d'au moins un contact métallique s'étendant, dans l'épaisseur d'un substrat semi-conducteur, le long d'au moins un flanc de la puce.

Selon un mode de réalisation, le contact métallique affleure à une face supérieure de la puce, ladite face étant plane.

Selon un mode de réalisation, la puce est uniquement recouverte du ou des contacts métalliques et d'une ou de résines de protection isolantes.

Selon un mode de réalisation, le contact métallique s'étend le long d'au moins un flanc de la puce sur une hauteur comprise entre 50 µm et 200 µm, de préférence de l'ordre de 100 µm.

Selon un mode de réalisation, les contacts métalliques sont en un alliage à base d'étain.

Selon un mode de réalisation, une face inférieure du substrat est recouverte d'une résine de protection isolante électriquement.

Selon un mode de réalisation, le contact métallique est, dans l'épaisseur du substrat, séparé du substrat par une couche d'isolation.

Selon un mode de réalisation, la puce a la forme d'un parallélépipède comprenant, au moins au niveau des contacts métalliques, un épaulement dans la hauteur de la puce.

Selon un mode de réalisation, le contact métallique s'étend en continu sur au moins une partie d'une face supérieure de la puce, sur au moins une partie d'une face latérale de la puce et sur au moins une partie d'une face de l'épaulement, parallèle à la face supérieure.

Selon un mode de réalisation, le procédé comprend au moins les étapes suivantes :
a1) former, du coté d'une face supérieure du substrat semi-conducteur, dans et sur lequel ont été préalablement formés une pluralité de circuits intégrés, des premières ouvertures séparant latéralement des circuits intégrés ;
b1) déposer, dans les premières ouvertures et sur une partie de la face supérieure du substrat, une couche en un matériau métallique ;
c1) former, à l'aplomb de la couche métallique, des bossages, les bossages recouvrant la couche métallique et au moins deux plots de reprise de contact métalliques de deux circuits intégrés voisins formés dans le même substrat ;
d1) former, à partir de la face supérieure du substrat, des premières tranchées de façon à individualiser chaque circuit intégré, les premières tranchées coupant les bossages et s'étendant sur une largeur inférieure ou égale à la largeur des premières ouvertures et sur une profondeur supérieure à la profondeur des premières ouvertures ;
e1) déposer, dans les premières tranchées et sur l'ensemble de la face supérieure du substrat une résine de protection isolante électriquement ;
f1) amincir le substrat par sa face supérieure de façon à retirer une partie de la résine de protection isolante et une partie des bossages ;
g1) amincir le substrat par sa face inférieure jusqu'à atteindre la résine de protection isolante située au fond des premières tranchées ;
h1) former, à partir de la face supérieure du substrat, des deuxièmes ouvertures à l'aplomb des premières ouvertures ; et
i1) découper la résine de protection à l'aplomb des premières tranchées, de façon à séparer les circuits intégrés en puces individuelles avec une largeur inférieure à la largeur des premières tranchées.

Selon un mode de réalisation, à l'étape h1), ce qui subsiste des bossages et de la couche métallique est coupé par les deuxièmes ouvertures de façon à former les contacts métalliques.

Selon un mode de réalisation, lors de l'étape b1) la couche métallique est moulée dans les premières ouvertures.

Selon un mode de réalisation, le remplissage des premières ouvertures par la couche métallique à l'étape b1) est réalisé par un procédé de dépôt par électroplacage.

Selon un mode de réalisation, les premières ouvertures et les deuxièmes ouvertures sont réalisées par ablation laser ou par sciage.

Selon un mode de réalisation, la puce comprend six faces planes organisées en un parallélépipède, la puce comprenant au moins un contact métallique formant un angle entre deux faces consécutives du parallélépipède, le contact s'étendant sur une partie de l'épaisseur du substrat.

Selon un mode de réalisation, le procédé comprend les étapes suivantes :
a2) former, du coté d'une face supérieure du substrat semi-conducteur, dans et sur lequel ont été préalablement formés une pluralité de circuits intégrés, des premières ouvertures séparant latéralement des circuits intégrés ;
b2) déposer, dans les premières ouvertures, une couche en une résine photosensible ;
c2) former des deuxièmes ouvertures localement dans la couche de résine photosensible dans les premières ouvertures sur une partie seulement de l'épaisseur de la couche de résine photosensible ;
d2) déposer, dans les deuxièmes ouvertures, une couche en un matériau métallique ;
e2) former, à l'aplomb de la couche métallique, des bossages, les bossages recouvrant la couche métallique et au moins deux plots de reprise de contact de deux circuits intégrés voisins formés dans le même substrat ;
f2) retirer la couche de résine photosensible dans l'ensemble de la structure et remplir les espaces laissés libres par une couche d'une résine de protection isolante ;
g2) amincir le substrat par sa face supérieure de façon à retirer une partie de la couche de résine de protection isolante et une partie des bossages de façon à former les contacts métalliques ;
h2) amincir le substrat par sa face inférieure jusqu'à atteindre résine de protection isolante au fond des premières ouvertures ; et
i2) déposer sur la face inférieure du substrat une autre couche de résine de protection isolante et découper la résine de protection isolante et les contacts métalliques en vis-à-vis des premières ouvertures avec une largeur inférieure à la largeur des premières ouvertures, de façon à séparer les circuits intégrés en puces individuelles et à dégager un flanc d'au moins un contact métallique de chaque circuit intégré.

Selon un mode de réalisation, la découpe à l'étape i2) est réalisée par sciage.

Selon un mode de réalisation, les premières ouvertures sont réalisées par ablation laser ou par sciage.

Selon un mode de réalisation, les deuxièmes ouvertures sont réalisées par photolithogravure ou par ablation laser.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, par une vue en coupe, un premier mode de réalisation d'une puce électronique ;
la figure 2 illustre, par une vue en coupe, une étape d'un exemple de procédé de fabrication de la puce électronique illustrée en figure 1 ;
la figure 3 illustre, par une vue en coupe, une autre étape d'un exemple de procédé de fabrication de la puce électronique illustrée en figure 1 ;
la figure 4 illustre, par deux vues de dessus, deux modes de réalisation de la structure illustrée en figue 3 ;
la figure 5 illustre, par une vue en coupe, encore une autre étape d'un exemple de procédé de fabrication de la puce électronique illustrée en figure 1 ;
la figure 6 illustre, par une vue en coupe, encore une autre étape d'un exemple de procédé de fabrication de la puce électronique illustrée en figure 1 ;
la figure 7 illustre, par une vue en coupe, encore une autre étape d'un exemple de procédé de fabrication de la puce électronique illustrée en figure 1 ;
la figure 8 illustre, par une vue en coupe, encore une autre étape d'un exemple de procédé de fabrication de la puce électronique illustrée en figure 1 ;
la figure 9 illustre, par une vue en coupe, encore une autre étape d'un exemple de procédé de fabrication de la puce électronique illustrée en figure 1 ;
la figure 10 illustre, par une vue en coupe, encore une autre étape d'un exemple de procédé de fabrication de la puce électronique illustrée en figure 1 ;
la figure 11 illustre, par une vue en coupe, encore une autre étape d'un exemple de procédé de fabrication de la puce électronique illustrée en figure 1 ;
la figure 12 illustre, par une vue en coupe, encore une autre étape d'un exemple de procédé de fabrication de la puce électronique illustrée en figure 1 ;
la figure 13 illustre, par une vue en coupe, encore une autre étape d'un exemple de procédé de fabrication de la puce électronique illustrée en figure 1 ;
la figure 14 illustre, par une vue en coupe, encore une autre étape d'un exemple de procédé de fabrication de la puce électronique illustrée en figure 1 ;
la figure 15 illustre, par deux vues de dessus, deux modes de réalisation de la structure illustrée en figue 14 ;
la figure 16 illustre, par une vue en coupe, un deuxième mode de réalisation d'une puce électronique ;
la figure 17 illustre, par une vue en coupe, une étape d'un exemple de procédé de fabrication de la puce électronique illustrée en figure 16 ;
la figure 18 illustre, par une vue en coupe et une vue de dessus, une autre étape d'un exemple de procédé de fabrication de la puce électronique illustrée en figure 16 ;
la figure 19 illustre, par une vue en coupe, encore une autre étape d'un exemple de procédé de fabrication de la puce électronique illustrée en figure 16 ;
la figure 20 illustre, par deux vues en coupe et une vue de dessus, encore une autre étape d'un exemple de procédé de fabrication de la puce électronique illustrée en figure 16 ;
la figure 21 illustre, par une vue en coupe, encore une autre étape d'un exemple de procédé de fabrication de la puce électronique illustrée en figure 16 ;
la figure 22 illustre, par une vue en coupe et une vue de dessus, encore une autre étape d'un exemple de procédé de fabrication de la puce électronique illustrée en figure 16 ;
la figure 23 illustre, par une vue en coupe et une vue de dessus, encore une autre étape d'un exemple de procédé de fabrication de la puce électronique illustrée en figure 16 ;
la figure 24 illustre, par deux vues en coupe et une vue de dessus, encore une autre étape d'un exemple de procédé de fabrication de la puce électronique illustrée en figure 16 ;
la figure 25 illustre, par une vue en coupe, encore une autre étape d'un exemple de procédé de fabrication de la puce électronique illustrée en figure 16 ;
la figure 26 illustre, par une vue en coupe, encore une autre étape d'un exemple de procédé de fabrication de la puce électronique illustrée en figure 16 ;
la figure 27 illustre, par une vue en coupe, encore une autre étape d'un exemple de procédé de fabrication de la puce électronique illustrée en figure 16 ;
la figure 28 illustre, par une vue en coupe, encore une autre étape d'un exemple de procédé de fabrication de la puce électronique illustrée en figure 16 ; et
la figure 29 illustre, par une vue en coupe, encore une autre étape d'un exemple de procédé de fabrication de la puce électronique illustrée en figure 16.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seules les étapes et éléments utiles à la compréhension des modes de réalisation décrits ont été représentés et sont détaillés. En particulier, la réalisation des circuits intégrés présents dans les puces électroniques décrites n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Une puce à flancs mouillables comporte des métallisations de connexion ayant une hauteur suffisamment importante afin que le contrôle visuel du brasage de la puce puisse être efficace. On considère généralement qu'un contrôle visuel du brasage est difficile lorsque les métallisations ont une hauteur inférieure à environ 100 µm. Les métallisations ont donc, de préférence, une hauteur supérieure à environ 100 µm dans les applications visées par la présente description.

Cette hauteur est l'un des points bloquants dans la miniaturisation des circuits électroniques basés sur de telles puces. En effet, les métallisations de connexion sont habituellement réalisées à la surface d'un substrat semi-conducteur et au dessus de circuit(s) intégré(s) qu'il comprend. L'épaisseur d'une puce électronique à flancs mouillables correspond donc, au minimum, à la hauteur des métallisations à laquelle s'ajoute l'épaisseur du substrat comprenant le ou les circuits intégrés.

Dans les modes de réalisation décrits, on prévoit de tirer profit de l'épaisseur du substrat en reportant une partie de la hauteur des métallisations dans l'épaisseur du substrat. En d'autres termes, on prévoit d'étendre les métallisations dans l'épaisseur du substrat, le long d'au moins un flanc de la puce. Les modes de réalisation décrits permettent ainsi de diminuer l'épaisseur des métallisations à la surface du substrat en reportant cette épaisseur dans l'épaisseur du substrat. Cela permet alors de diminuer l'épaisseur totale des puces à flancs mouillables.

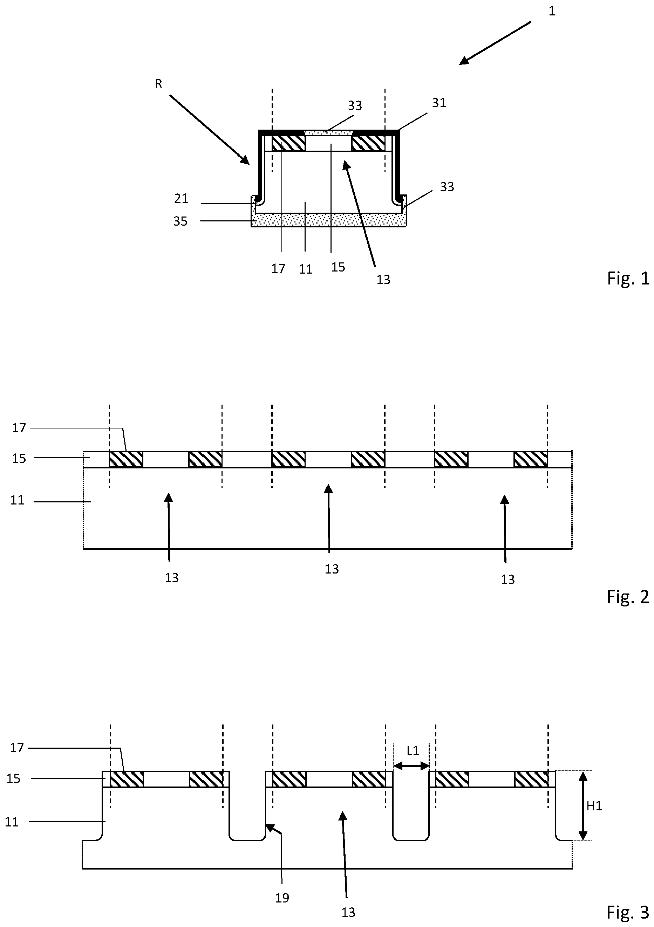

La figure 1 illustre, par une vue en coupe, partielle et schématique, un premier mode de réalisation d'une puce électronique 1.

La puce électronique 1 comprend un substrat semi-conducteur 11 dans et sur lequel est formé un ou des circuits intégré 13. Le substrat 11 est en un matériau semi-conducteur comme du silicium. Le substrat 11 et le circuit intégré 13 sont surmontés d'un empilement de couches isolantes et conductrices 15 appelé empilement d'interconnexion, dans lequel peuvent être formés des éléments d'interconnexion des composants du circuit 13. L'empilement d'interconnexion 15 comprend en outre, un ou plusieurs plots de reprise de contact 17 qui peuvent être métalliques, par exemple deux plots 17 comme cela est illustré en figure 1. Les plots de reprise de contact 17 affleurent à la surface de la structure formée du substrat 11, du ou des circuits intégrés 13 et de l'empilement 15 et sont destinés à être connectés à un dispositif extérieur.

La structure formée par le substrat 11, l'empilement 15 et les plots de reprise de contact 17 a une forme parallélépipédique. Selon le mode de réalisation, cette structure peut comprendre un ou des retraits latéraux R, ou épaulement, dans la hauteur de la puce 1 qui seront détaillés ultérieurement.

La puce 1 illustrée en figure 1 comprend en outre des contacts métalliques 31. Chaque contact métallique 31 est, formé sur et en contact avec un plot de reprise de contact 17 et s'étend en continu sur au moins une partie de la face supérieure du substrat 11 (ou de la puce), au moins un des flancs latéraux du substrat 11 (ou de la puce), et au moins une partie d'une face de l'épaulement, parallèle à la face supérieure. Les contacts métalliques 31 s'étendent donc le long du substrat 11 dans l'épaisseur de celui-ci.

Selon le mode de réalisation illustré en figure 1, tous les plots de reprise de contact 17 sont recouverts par un contact métallique 31.

A titre d'exemple, dans les retraits R, les contacts métalliques 31 sont séparés du substrat 11 par une couche d'isolation 21.

Les parties de la structure, formée par le substrat 11, l'empilement 15 et les plots de reprise de contact 17, qui ne sont pas recouvertes par un contact métallique 31 sont recouvertes par une ou des résines de protection isolantes. Par exemple, une partie de la face supérieure et une partie des bords latéraux de la structure sont recouvertes par une couche de résine 33 et la face inférieure de la structure est recouverte par une couche de résine 35.

Les figures 2 à 15 sont des vues en coupe et de dessus illustrant des étapes successives d'un exemple d'un procédé de fabrication de puces électroniques selon un premier mode de réalisation.

La figure 2 est une vue en coupe d'une structure de départ comprenant le substrat semi-conducteur 11 dans et sur lequel des circuits intégrés 13 ont été préalablement formés. Les circuits 13 sont par exemple tous identiques aux dispersions de fabrication près. Le substrat 11 peut correspondre à une plaquette d'un matériau semi-conducteur, par exemple du silicium. Le substrat 11 a, par exemple, une épaisseur comprise entre 300 µm et 900 µm, par exemple une épaisseur d'environ 500 µm.

La structure de la figure 2 comprend en outre l'empilement de couches isolantes et conductrices 15 revêtant la face supérieure du substrat 11. L'empilement d'interconnexion 15 comprend en outre, pour chaque circuit intégré 13, un ou plusieurs plots de reprise de contact 17. Dans l'exemple de la figure 2, deux plots de reprise de contact 17 sont représentés pour chaque circuit 13. Toutefois, le nombre de plots de reprise de contact 17 par circuit 13 peut être différent de deux.

Chaque circuit intégré 13 comprend, par exemple, un ou plusieurs composants électroniques (transistors, diodes, thyristors, triacs, etc.).

En figure 2, trois circuits intégrés 13 ont été représentés, étant entendu que le nombre de circuits intégrés 13 formés dans et sur le substrat 11 peut être différent de trois. En pratique, le substrat 11 est une plaquette en un matériau semi-conducteur, par exemple, du silicium, et plusieurs dizaines voire plusieurs centaines de circuits intégrés 13 sont formés dans et sur le substrat 11. Les circuits intégrés 13 sont alors organisés en réseau en lignes et en colonnes en suivant un quadrillage régulier.

Dans la suite de cette description, on considère, dans l'orientation de la figure 2, la face inférieure de la structure comme étant la face arrière et la face supérieure de la structure comme étant la face avant.

La figure 3 illustre, par une vue en coupe, une étape a1) de formation d'ouvertures 19, en face avant de la structure de départ illustrée en figure 2.

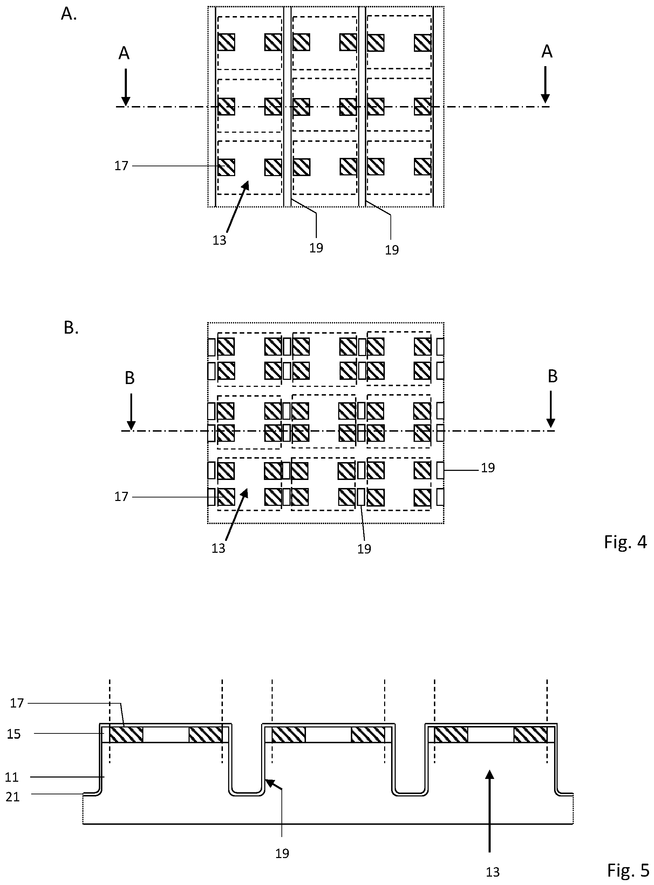

La figure 4 illustre, par deux vues de dessus (A) et (B), deux modes de réalisation de la structure illustrée en figue 3. La figure 3 correspond alors à une coupe selon le plan de coupe A-A de la vue (A) de la figure 4 ou à une coupe selon le plan de coupe B-B de la vue (B) de la figure 4.

Dans l'exemple représenté, les ouvertures 19 s'étendent verticalement, depuis la face supérieure de l'empilement 15, et se prolongent dans le substrat 11. Dans cet exemple, les ouvertures 19 sont non traversantes, c'est-à-dire qu'elles ne débouchent pas du côté de la face inférieure du substrat 11. Les ouvertures 19 s'étendent verticalement sur une profondeur H1, par exemple comprise entre 50 µm et 200 µm, de préférence de l'ordre de 120 µm. Les ouvertures 19 ont par exemple une largeur L1 comprise entre 20 µm et 100 µm, de préférence comprise entre 40 µm et 70 µm, la largeur L1 étant préférentiellement égale à environ 55 µm, par exemple égale à 55 µm.

Selon le mode de réalisation illustré en vue (A) de la figure 4, les ouvertures 19 s'étendent entre les circuits 13 de sorte que, en vue de dessus, chaque colonne de circuits 13 soit séparée de la colonne de circuits 13 voisine par une ouverture 19. Les ouvertures 19 sont formées de sorte qu'elles passent au voisinage des plots de reprise de contact 17 des circuits intégrés 13 (par exemple à moins de 10 µm, sans toutefois, de préférence, les atteindre). Les ouvertures 19 sont alors, par exemple, réalisées par sciage ou par gravure. Lors de l'étape de formation des ouvertures 19, la structure peut être montée sur un film support, non représenté, disposé du coté de la face inférieure du substrat 11, le film étant retiré après la formation des ouvertures 19.

Selon le mode de réalisation illustré en vue (B) de la figure 4, les ouvertures 19 sont formées entre les circuits 13 de sorte qu'il y a au moins une ouverture 19 en vis à vis de chaque plot de reprise de contact 17. A titre d'exemple, une ouverture 19 peut être située en vis-à-vis de plusieurs plots de reprise de contact 17 du même circuit 13 ou de deux circuits 13 voisins. Les ouvertures 19 sont alors, par exemple, réalisées par ablation laser ou par gravure. Lors de l'étape de formation des ouvertures 19, la structure peut être montée sur un film support, non représenté, disposé du coté de la face inférieure du substrat 11, le film étant retiré après la formation des ouvertures 19.

La figure 5 illustre par une vue en coupe une étape de dépôt d'une couche d'isolation 21, en face avant de la structure obtenue à l'issue des étapes des figures 2 et 3.

Selon un mode de réalisation, la couche 21 est une couche en un diélectrique, par exemple en dioxyde de silicium (SiO₂).

Selon un mode de réalisation, la couche 21 est, par exemple, formée pleine plaque, c'est-à-dire que la couche 21 recouvre la face supérieure de la structure obtenue à l'issue des étapes des figures 2 et 3 ainsi que les bords latéraux et le fond des ouvertures 19.

Selon un autre mode de réalisation, la couche 21 n'est pas formée pleine plaque et est formée localement par croissance via une oxydation sèche ou humide.

Selon un mode de réalisation, la couche 21 a, par exemple, une épaisseur comprise entre 1 µm et 6 µm.

Selon un autre mode de réalisation, en fin de gravure des ouvertures 19, un résidu de polymère subsiste au fond et sur les bords latéraux des ouvertures 19. Ce polymère peut servir de couche isolante 21.

Selon un autre mode de réalisation, la couche 21 est, en partie, une couche de silicium poreux formée, dans les ouvertures 19, ou une couche isolante formée par une gravure ionique réactive profonde ou DRIE (de l'anglais "Deep Reactive Ion Etching").

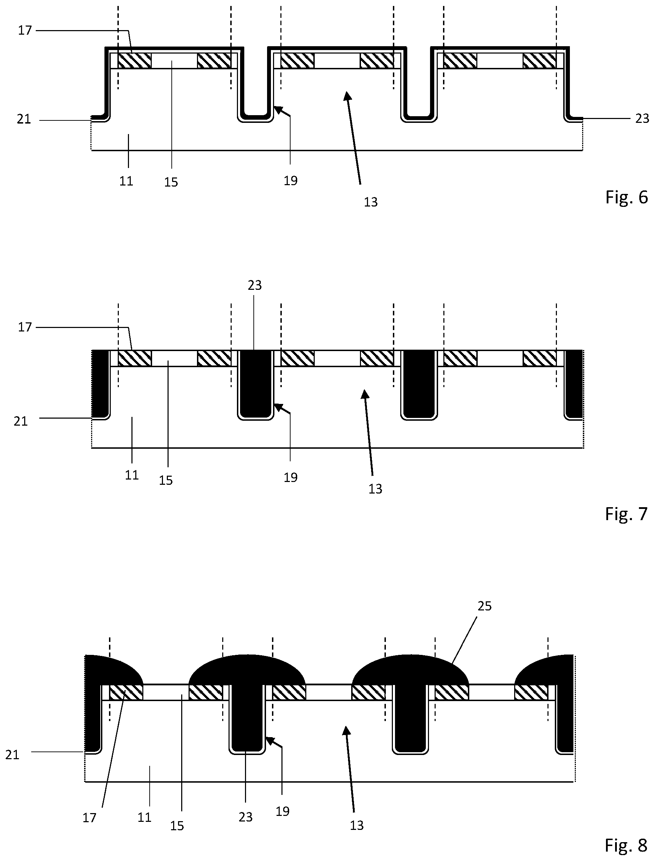

La figure 6 illustre par une vue en coupe une étape de dépôt d'une couche 23 en un matériau métallique, en face avant de la structure obtenue à l'issue des étapes des figures 2 à 5.

Selon le mode de réalisation illustré en figure 6, la couche 23 est formée pleine plaque, c'est-à-dire que la couche 23 recouvre la face supérieure de la structure obtenue à l'issue des étapes des figures 2 à 5 et les bords latéraux et le fond des ouvertures 19. La couche 23 est, par exemple en un alliage de cuivre et/ou en un alliage d'étain et/ou en un alliage d'argent ou en tout autre matériau adapté à être brasé. A titre d'exemple, la couche 23 est en un alliage d'étain et d'argent (SnAg).

La figure 7 illustre par une vue en coupe une étape b1) de comblement des ouvertures 19 de la structure obtenue à l'issue des étapes des figures 2 à 6.

Selon le mode de réalisation illustré en figure 7, le matériau de la couche 23 est déposé de façon à remplir les ouvertures 19. Le dépôt de la couche 23 est par exemple, réalisée par électroplacage également appelé placage par galvanoplastie (en anglais "electroplating"). Le matériau métallique se retrouve ainsi moulé dans les ouvertures 19.

Selon un mode de réalisation, l'étape illustrée en figure 7 est suivie d'une étape de polissage mécanique ou polissage mécano-chimique (CMP, de l'anglais "Chemical mechanical polishing"). L'étape de CMP permet de retirer les portions des couches 21 et 23 situées sur la face avant de la structure. En d'autres termes, l'étape de CMP permet de découvrir la face supérieure de la couche 15 et des plots de reprise de contact 17.

La figure 8 illustre par une vue en coupe une étape c1) de formation de bossages 25 en un matériau métallique sur la face supérieure de la structure obtenue à l'issue des étapes des figures 2 à 7.

Les bossages 25 sont, de préférence, en le même matériau que la couche 23. Toutefois, les matériaux des couches 25 et 23 peuvent être différents.

Chaque bossage 25 est, selon le mode de réalisation illustré en figure 8, réalisé de façon à recouvrir une unique ouverture 19 en se prolongeant de façon à recouvrir les plots de reprise de contact 17 voisins. En d'autres termes, chaque bossage 25 est réalisé de sorte qu'il connecte électriquement le matériau de la couche 23 situé dans l'ouverture 19 qu'il recouvre et les plots de reprise de contact 17 de deux circuits 13 séparés par cette même ouverture 19. Les plots de reprise de contact 17 recouverts par un même bossage 25 sont les plots de reprise de contact 17 situés en vis-à-vis de cette même ouverture 19. On notera que les bossages 25 n'ont, comme on le verra par la suite, pas vocation à former des interconnexions fonctionnelles entre deux puces voisines.

Les bossages 25 sont, selon un mode de mise en oeuvre, formés par sérigraphie ou par croissance électrolytique.

Les bossages 25 sont, selon un autre mode de mise en oeuvre, formés par dépôt métallique à travers un masque.

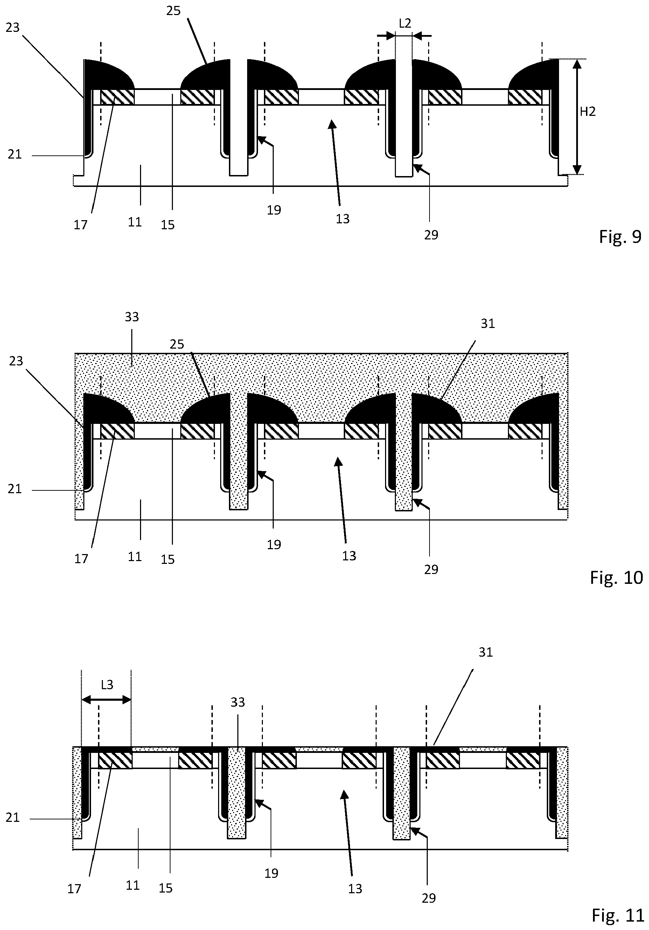

La figure 9 illustre par une vue en coupe une étape d1) de formation de tranchées 29, dans les bossages 25 et la couche 23, à partir de la face supérieure de la structure obtenue à l'issue des étapes des figures 2 à 8.

Les tranchées 29 s'étendent entre les circuits 13 de sorte que, en vue de dessus, chaque circuit 13 soit séparé de son voisin par une tranchée 29. A titre d'exemple, chaque circuit 13 est entièrement délimité, latéralement, par des tranchées 29. Les tranchées 29 peuvent, par exemple, en vue de dessus, former une grille continue s'étendant entre les circuits intégrés 13 en vue de l'individualisation des puces. A ce titre, les tranchées 29 sont réalisées au moins au droit des ouvertures 19. Les tranchées 29 sont, par exemple, réalisées par sciage.

L'opération de sciage coupe les bossages 25 et la couche 23, de façon à séparer chaque bossage 25 et chaque partie de la couche 23 en deux portions, destinées à former les contacts métalliques 31 illustrés en figure 1.

Selon un mode de réalisation, les tranchées 29 s'étendent verticalement, depuis la face supérieure de la structure obtenue à l'issue des étapes des figures 2 à 8. Dans cet exemple, les tranchées 29 sont non traversantes, c'est-à-dire qu'elles ne débouchent pas du côté de la face inférieure du substrat 11.

Les tranchées 29 s'étendent verticalement sur une profondeur H2, par exemple supérieure à la profondeur des circuits intégrés 13. La profondeur H2 est calculée de sorte que les tranchées 29 s'étendent plus profondément dans le substrat 11 que le fond des ouvertures 19. La profondeur H2 est comprise, par exemple, entre 100 µm et 400 µm, de préférence entre 100 µm et 200 µm. Les tranchées 29 ont une largeur L2 inférieure à la largeur L1. La largeur L2 est, par exemple, comprise entre 5 µm et 80 µm, de préférence comprise entre 15 µm et 25 µm.

La figure 10 illustre par une vue en coupe une étape e1) de dépôt d'une résine de protection 33 sur l'ensemble de la face supérieure de la structure obtenue à l'issue des étapes des figures 2 à 9.

Plus particulièrement, on vient recouvrir intégralement la face supérieure de la structure obtenue à l'issue des étapes des figures 2 à 9, et en particulier recouvrir ce qui subsiste des bossages 25 et combler les tranchées 29 par la résine de protection 33. La résine 33 est, par exemple, une résine époxy.

La figure 11 illustre par une vue en coupe une étape f1) de planarisation de la face supérieure de la structure obtenue à l'issue des étapes des figures 2 à 10. La planarisation est, par exemple, réalisée par CMP. Lors de cette étape, une partie supérieure de la résine de protection 33 est retirée. L'étape de planarisation se poursuit jusqu'à amincir ce qui subsiste des bossages 25 pour former les contacts métalliques 31. Ainsi, les contacts métalliques 31 affleurent à la surface de la face supérieure de ce qui subsiste de la couche de résine 33 entre ces contacts.

Plus particulièrement, la planarisation est effectuée jusqu'à découvrir les contacts métalliques 31 sur une longueur L3 (dans le plan de la puce) supérieure à 20 µm et sur une largeur supérieure à 100 µm. La longueur L3 est, par exemple, comprise entre 20 µm et 600 µm, de préférence comprise entre 100 µm et 300 µm. La largeur des contacts métalliques 31 est, par exemple à l'issue de l'étape de planarisation, comprise entre 100 µm et 600 µm, de préférence comprise entre 100 µm et 400 µm. Ces dimensions sont choisies en fonction de la largeur des tranchées 29 et des dimensions des plots de reprise de contact 17.

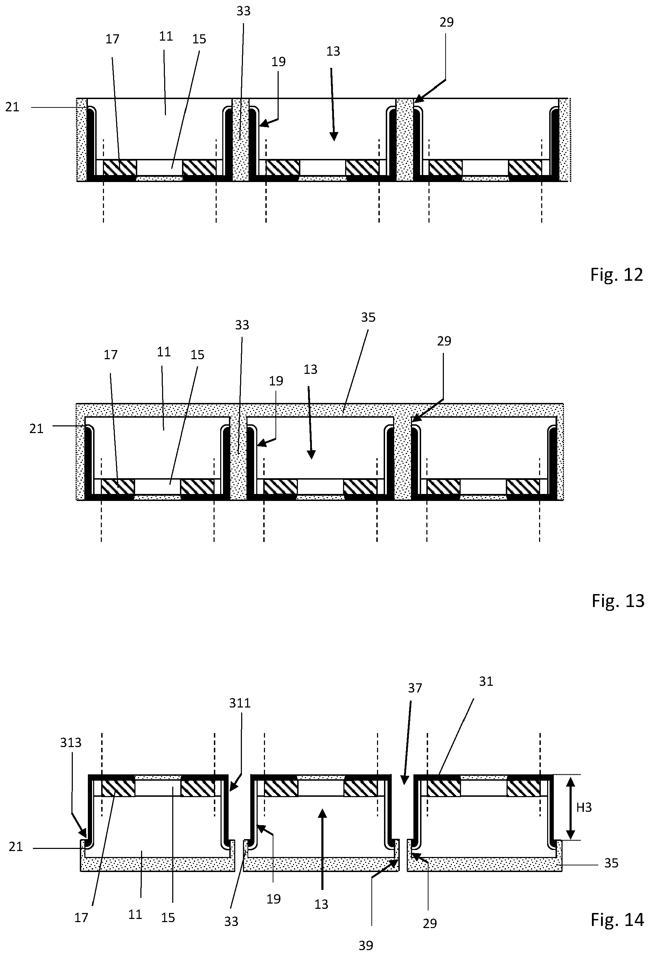

La figure 12 illustre par une vue en coupe une étape g1) de planarisation de la face inférieure de la structure obtenue à l'issue des étapes des figures 2 à 11.

On notera que dans l'exemple de la figure 12, l'orientation de la structure est inversée par rapport aux vues en coupe des figures précédentes.

Le substrat 11 est aminci par sa face arrière (face supérieure en figure 12), par exemple par CMP. Dans cet exemple, le substrat 11 est aminci par sa face arrière jusqu'à atteindre au moins le fond des tranchées 29, de sorte que, après amincissement, la résine 33 présente dans les tranchées 29 affleure à la surface de la face arrière du substrat 11. A l'issue de cette étape, les circuits intégrés 13 ne sont plus reliés entre eux que par ce qui subsiste de la couche 33 et, éventuellement, un film support, non représenté en figure 12, fixé sur la face supérieure de la structure.

La figure 13 illustre par une vue en coupe une étape de dépôt d'une résine de protection 35 sur la face arrière de la face inférieure de la structure obtenue à l'issue des étapes des figures 2 à 12.

La couche 35 s'étend par exemple pleine plaque, de façon continue, et sur une épaisseur sensiblement constante sur toute la surface de la face arrière de la structure. La couche 35 a, par exemple, une épaisseur comprise entre 10 µm et une épaisseur selon la dimension finale du boitier. L'épaisseur de la couche 35 est, de préférence, comprise entre 10 µm et 100 µm, par exemple de l'ordre de 25 µm. Les résines des couches 35 et 33 peuvent être de même composition ou de compositions différentes.

La figure 14 illustre par une vue en coupe une étape d'individualisation des puces. Cette étape comprend la formation (étape h1)) d'ouvertures 37, au droit (à l'aplomb) des ouvertures 19, et la formation (étape i1)) de tranchées 39, au droit des tranchées 29, à partir de la face avant de la structure obtenue à l'issue des étapes des figures 2 à 13.

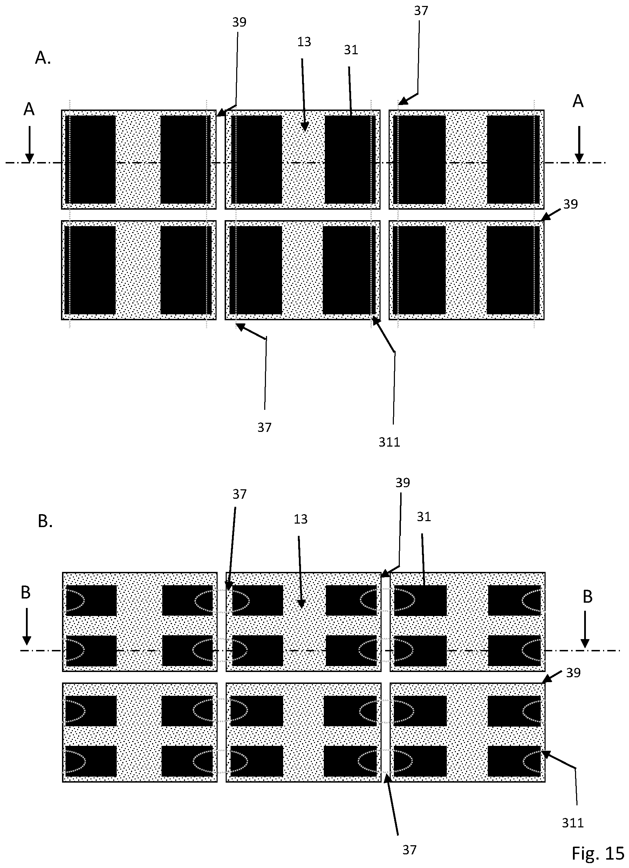

La figure 15 illustre, par deux vues de dessus (A) et (B), deux modes de réalisation de la structure illustrée en figure 14, la figure 14 correspondant alors à une coupe selon le plan de coupe A-A de la vue (A) de la figure 15 ou à une coupe selon le plan de coupe B-B de la vue (B) de la figure 15.

Plus particulièrement la figure 14 illustre une étape comprenant la formation d'ouvertures 37 au droit des ouvertures 19 permettant de faire apparaître les flancs des contacts métalliques 31 et la formation de tranchées 39 au droit des tranchées 29 permettant de découper la structure en puces individuelles comprenant chacune un unique circuit intégré 13.

Les ouvertures 37 s'étendent verticalement, depuis la face supérieure de la structure, sur une profondeur H3. La profondeur H3 est calculée de sorte que les ouvertures 37 ne s'étendent pas jusqu'au fond des ouvertures 19. La profondeur H3 est donc inférieure à la profondeur H1 (figure 3). La profondeur H3 correspond, à l'issue de l'étape illustrée en figures 14 et 15, à la hauteur de la métallisation sur le flanc de la puce. La profondeur H3 est, par exemple, de l'ordre de 100 µm.

Les ouvertures 37 sont réalisées dans le remplissage réalisé préalablement dans les ouvertures 19 et ont la même forme que les ouvertures 19 aux dimensions près.

Si les ouvertures 19 correspondent à des tranchées non traversantes s'étendant sur et dans toute la longueur du substrat 11 comme illustrée en vue (A) de la figure 4, les ouvertures 37 correspondent à des tranchées non traversantes s'étendant sur et dans toute une longueur du substrat 11. En variante, si les ouvertures 19 correspondent à des ouvertures localisées dans le substrat 11 comme illustré en vue (B) de la figure 4, les ouvertures 37 correspondent à des ouvertures localisées au droit des ouvertures 19.

Les ouvertures 37 présentent une largeur supérieure ou égale à la largeur des ouvertures 19. Plus particulièrement, dans cet exemple, la largeur de chaque ouverture 37 est choisie suffisamment grande pour permettre de dégager un flanc 311 d'au moins un contact métallique 31 de chacun des circuits intégrés 13 situés de part et d'autre de l'ouverture 37 ou de la portion d'ouverture 37.

A titre d'exemple, après la formation des ouvertures 37, au moins un flanc 311 d'au moins un contact métallique 31 de chaque circuit 13 est exposé.

Pour former les ouvertures 37, on réalise un retrait partiel de la résine 33 située dans les tranchées 29. Le retrait partiel de la résine 33 est éventuellement accompagné d'un retrait d'une partie des contacts métalliques 31 situées, en vue de dessus, de part et d'autre des tranchées 29. Dans l'exemple représenté, une partie des contacts métalliques 31 situées de part et d'autre des tranchées 29 est retirée, ce qui conduit à la formation de marches 313 sur les contacts métalliques 31.

Selon le mode de réalisation illustré en vue (A) de la figure 15, les ouvertures 37 peuvent être réalisées par sciage, en utilisant une lame de découpe de largeur supérieure à celle utilisée pour la réalisation des tranchées 29 et inférieure à celle utilisée pour la réalisation des ouvertures 19. Les ouvertures 37 peuvent, en variante, être réalisées par tout autre moyen de découpe, par exemple, par découpe laser.

Les tranchées 39 sont réalisées dans la résine 33, au droit des tranchées 29. Plus particulièrement, dans cet exemple, on vient former au droit de chaque tranchée 29, une tranchée 39 parallèle à la tranchée 29 s'étendant sur toute la longueur de la tranchée 29. Les tranchées 39 s'étendent, verticalement, sur toute l'épaisseur de la structure. La largeur des tranchées 39 est inférieure à celle des tranchées 29 de façon que, après formation des tranchées 39, chaque circuit intégré 13, et par conséquent chaque puce 1, reste recouvert par de la résine 33 ou 35 sur toutes ses faces à l'exception des contacts métalliques 31 formant les flancs mouillables de la puce. A titre d'exemple, à l'issue de l'étape illustrée en figure 15, la face supérieure de la puce est plane, les contacts métalliques 31 affleurant à la face supérieure de ce qui subsiste de la résine de protection 33.

A l'issue de cette étape, la structure obtenue correspond à une pluralité de puces électroniques. Les flancs 311 des contacts métalliques 31 exposés à l'étape des figures 14 et 15 (formation des ouvertures 37) correspondent à des flancs mouillables des puces.

L'étape illustrée en figures 14 et 15 est précédée d'une étape de report de la structure obtenue à l'issue des étapes des figures 2 à 12, de préférence, par sa face arrière, sur un film support permettant aux puces d'être maintenues ensemble. Les puces peuvent ensuite être prélevées sur le film support.

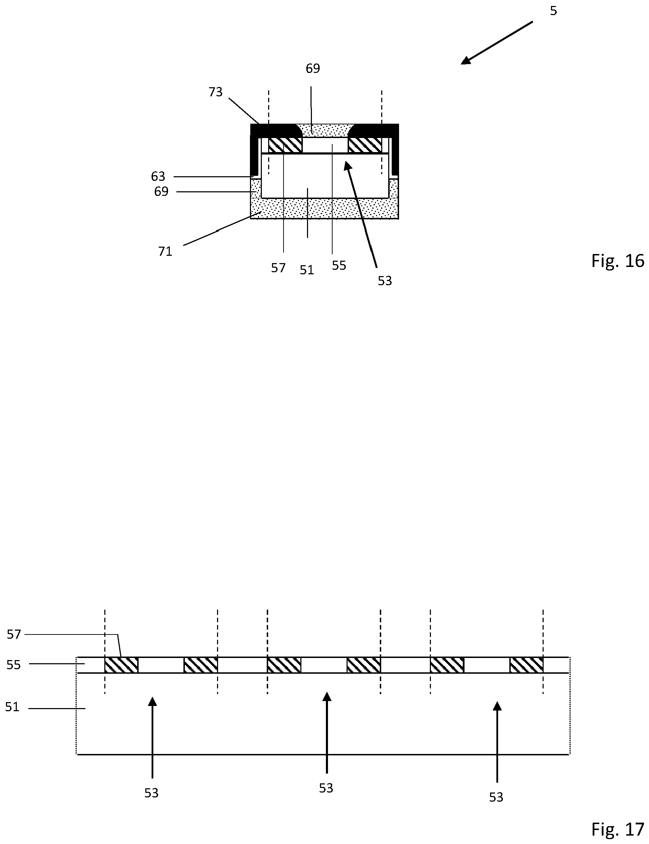

La figure 16 illustre, par une vue en coupe, partielle et schématique, un deuxième mode de réalisation d'une puce électronique 5.

La puce électronique 5 comprend un substrat semi-conducteur 51 dans et sur lequel est formé un circuit intégré 53. Le substrat 51 est en un matériau semi-conducteur comme du silicium. Le substrat 51 et le circuit intégré 53 sont surmontés d'un empilement de couches isolantes et conductrices 55 appelé empilement d'interconnexion, dans lequel peuvent être formés des éléments d'interconnexion des composants du circuit 53. L'empilement d'interconnexion 55 comprend en outre, un ou plusieurs plots de reprise de contact 57 qui peuvent être métalliques, par exemple deux plots 57 comme cela est illustré en figure 16. Les plots de reprise de contact 57 affleurent à la surface de la structure formée du substrat 51, du ou des circuits intégrés 53 et de l'empilement 55 et sont destinés à être connectés à un dispositif extérieur.

La structure formée par le substrat 51, l'empilement 55 et les plots de reprise de contact 57 a une forme, de préférence, parallélépipédique, par exemple une forme cubique ou la forme d'un pavé dont les six faces sont planes.

La puce 5 illustrée en figure 16 comprend en outre des contacts métalliques 73. Chaque contact métallique 73 est, formé sur et en contact avec un plot de reprise de contact 57 et s'étend sur une partie des flancs latéraux du substrat 51. Les contacts métalliques 73 s'étendent donc le long du substrat 51 dans l'épaisseur de celui-ci. Chaque contact métallique 73 affleure à une face supérieure de la puce 5.

Selon le mode de réalisation illustré en figure 16, tous les plots de reprise de contact 57 sont recouverts par un contact métallique 73.

A titre d'exemple, les contacts métalliques 73 sont séparés du substrat 51 par une couche d'isolation 63.

Les parties de la structure, formée par le substrat 51, l'empilement 55 et les plots de reprise de contact 57, qui ne sont pas recouvertes par un contact métallique 73 sont recouvertes par une ou des résines de protection isolantes. Par exemple, une partie de la face supérieure et une partie des bords latéraux de la structure sont recouvertes par une couche de résine 69 et la face inférieure de la structure est recouverte par une couche de résine 71.

Les figures 17 à 29 sont des vues en coupe et de dessus illustrant des étapes successives d'un exemple d'un procédé de fabrication de puces électroniques selon un deuxième mode de réalisation.

La figure 17 est une vue en coupe d'une structure de départ comprenant le substrat semi-conducteur 51 dans et sur lequel des circuits intégrés 53 ont été préalablement formés. Les circuits 53 sont par exemple tous identiques aux dispersions de fabrication près. Le substrat 51 peut correspondre à une plaquette d'un matériau semi-conducteur, par exemple du silicium. Le substrat 51 a, par exemple, une épaisseur comprise entre 300 µm et 900 µm, par exemple une épaisseur d'environ 500 µm.

La structure de la figure 17 comprend, en outre, l'empilement de couches isolantes et conductrices 55 revêtant la face supérieure du substrat 51. L'empilement d'interconnexion 55 comprend, en outre, pour chaque circuit intégré 53, un ou plusieurs plots de reprise de contact 57. Dans l'exemple de la figure 17, deux plots de reprise de contact 57 sont représentés pour chaque circuit 53. Toutefois, le nombre de plot de reprise de contact 57 par circuit 53 peut être différent de deux.

Chaque circuit intégré 53 comprend, par exemple, un ou plusieurs composants électroniques (transistors, diodes, thyristors, triacs, etc.).

En figure 17, trois circuits intégrés 53 ont été représentés, étant entendu que le nombre de circuits intégrés 53 formés dans et sur le substrat 51 peut être différent de trois. En pratique, le substrat 51 est une plaquette en un matériau semi-conducteur, par exemple, du silicium, et plusieurs dizaines voire plusieurs centaines de circuits intégrés 53 sont formés dans et sur le substrat 51. Les circuits intégrés 53 sont alors organisés en réseau en lignes et en colonnes en suivant un quadrillage régulier.

Dans la suite de cette description, on considère, dans l'orientation de la figure 17, la face inférieure de la structure comme étant la face arrière et la face supérieure de la structure comme étant la face avant.

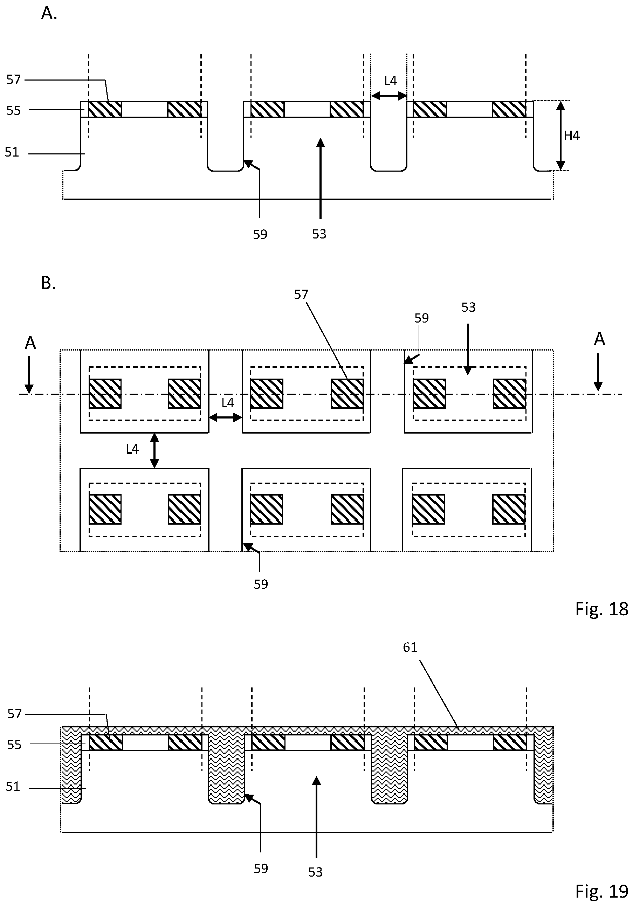

La figure 18 illustre, par une vue en coupe (A) et une vue de dessus (B), une étape a2) de formation d'ouvertures 59, en face avant de la structure de départ illustrée en figure 17.

La vue (A) est une vue en coupe selon le plan de coupe A-A de la vue (B).

Les ouvertures 59 s'étendent entre les circuits 53 de sorte que, en vue de dessus, chaque circuit 53 soit séparé de son voisin par une ouverture 59. A titre d'exemple, chaque circuit 53 est entièrement délimité, latéralement, par des ouvertures 59. Les ouvertures 59 peuvent, par exemple, en vue de dessus, former une grille continue s'étendant entre les circuits intégrés 53.

Dans l'exemple représenté, les ouvertures 59 s'étendent verticalement, depuis la face supérieure de l'empilement 55, et se prolongent dans le substrat 51. Dans cet exemple, les ouvertures 59 sont non traversantes, c'est-à-dire qu'elles ne débouchent pas du côté de la face inférieure du substrat 51. Les ouvertures 59 s'étendent verticalement sur une profondeur H4, par exemple comprise entre 50 µm et 200 µm, de préférence de l'ordre de 120 µm. Les ouvertures 59 ont par exemple une largeur L4 comprise entre 20 µm et 100 µm, de préférence comprise entre 40 µm et 70 µm, la largeur L4 étant préférentiellement égale à environ 55 µm, par exemple égale à 55 µm.

Les ouvertures 59 sont, par exemple, réalisées par sciage, par gravure ou par ablation laser. Lors de l'étape de formation des ouvertures 59, la structure peut être montée sur un film support, non représenté, disposé du coté de la face inférieure du substrat 51, le film étant retiré après la formation des ouvertures 59.

La figure 19 illustre par une vue en coupe une étape b2) de dépôt d'une résine 61 sur l'ensemble de la face supérieure de la structure obtenue à l'issue des étapes des figures 16 à 18.

Plus particulièrement, lors de cette étape, on vient recouvrir intégralement la face supérieure de la structure obtenue à l'issue des étapes des figures 16 à 18, et en particulier combler les ouvertures 59 par la couche de résine 61. La résine de la couche 61 est, par exemple, une résine photosensible, de préférence négative. La résine de la couche 61 est, par exemple, la résine SU-8.

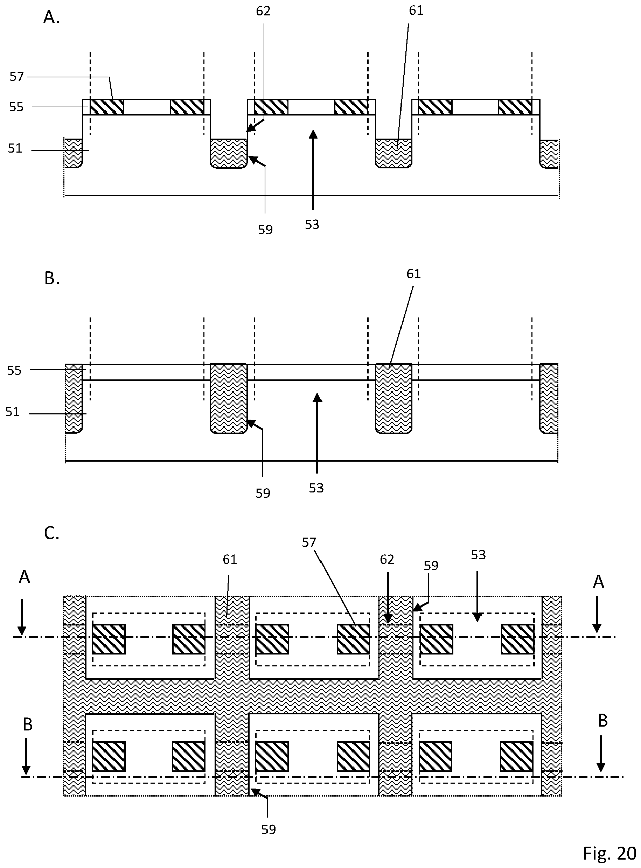

La figure 20 illustre, par deux vues en coupe (A) et (B) et une vue de dessus (C), une étape c2) de retrait partiel de la résine de la couche 61 à partir de la face avant de la structure obtenue à l'issue des étapes des figures 16 à 19.

La vue (A) est une vue en coupe selon le plan de coupe A-A de la vue (C) et la vue (B) est une vue en coupe selon le plan de coupe B-B de la vue (C).

Plus particulièrement, on vient, lors de cette étape, réaliser des ouvertures 62, dans les ouvertures 59 remplies de la couche 61, entre les circuits 13 de sorte qu'il y a au moins une ouverture 62 en vis à vis de chaque plot de reprise de contact 57. A titre d'exemple, une ouverture 62 peut être située en vis-à-vis de plusieurs plots de reprise de contact 57 du même circuit 53 ou de deux circuits 53 voisins.

Les ouvertures 62 s'étendent verticalement dans la couche 61 sur une profondeur, par exemple, inférieure à la profondeur des ouvertures 59. En effet, la profondeur des ouvertures 62 est calculée de sorte que les ouvertures 62 ne s'étendent pas plus profondément que le fond des ouvertures 59. La profondeur des ouvertures 62 correspond sensiblement à la hauteur des contacts métallisations 73 de la puce en fin de procédé de fabrication. A titre d'exemple, les ouvertures 62 sont formées de sorte que l'épaisseur de ce qui subsiste de la couche 61 au fond des ouvertures 59, à l'issue de l'étape illustrée en figure 20, soit environ supérieure à 10 µm, de préférence "gale à 20 µm.

Les ouvertures 62 sont, par exemple, réalisées par un procédé de photolithogravure ou par ablation laser.

L'étape de formation des ouvertures 62, est, par exemple, suivie d'une étape de polissage mécanique ou mécano-chimique (CMP, de l'anglais "Chemical mechanical polishing"). L'étape de CMP permet de retirer les portions de la couche 61 située sur la face avant de la structure. En d'autres termes, l'étape de CMP permet de découvrir la face supérieure de la couche 15 et des plots de reprise de contact 17. A titre d'exemple, l'étape de CMP et l'étape de formation des ouvertures 62 peuvent être inversées de sorte que l'étape de formation des ouvertures 62 suive l'étape de CMP.

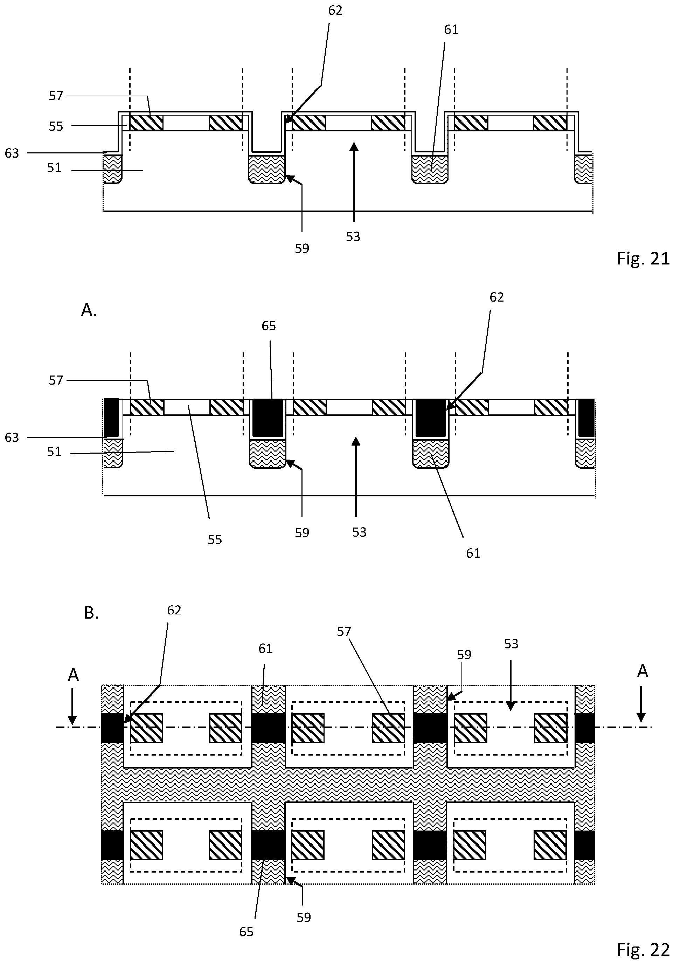

La figure 21 illustre par une vue en coupe une étape de dépôt conforme d'une couche d'isolation 63, en face avant de la structure obtenue à l'issue des étapes des figures 16 à 20.

Selon le mode de réalisation illustré en figure 21, la couche 63 est formée pleine plaque, c'est-à-dire que la couche 63 recouvre la face supérieure de la structure obtenue à l'issue des étapes des figures 16 à 20 ainsi qu'une partie des bords latéraux et le fond des ouvertures 62. La couche 63 a, par exemple, une épaisseur comprise entre 1 µm et 6 µm.

Selon un mode de réalisation, la couche 63 est une couche en dioxyde de silicium (SiO₂).

Selon un mode de réalisation, la couche 63 est formée par croissance via une oxydation sèche ou humide.

Selon un autre mode de réalisation, une partie de la couche 63, située au niveau des bords latéraux des ouvertures 62, est en silicium poreux formée, dans les ouvertures 62 ou est en un insolant formé par une gravure ionique réactive profonde ou DRIE (de l'anglais "Deep Reactive Ion Etching").

La figure 22 illustre, par une vue en coupe (A) et une vue de dessus (B), une étape d2) de dépôt d'une couche 65 en un matériau métallique au dessus de ce qui subsiste de la couche 61 dans les ouvertures 62, de la structure obtenue à l'issue des étapes des figures 16 à 21. La vue (A) est une vue en coupe selon le plan de coupe A-A de la vue (B).

Selon le mode de réalisation illustré en figure 22, le matériau de la couche 65 est déposé de façon à remplir les ouvertures 62. Le dépôt de la couche 65 est par exemple, réalisé par électroplacage également appelé placage par galvanoplastie (en anglais "electroplating"). Le matériau métallique de la couche 65 se retrouve ainsi moulé dans les ouvertures 62.

Selon un mode de réalisation, l'étape illustrée en figure 22 est suivie d'une étape de polissage mécanique ou plissage mécano-chimique. L'étape de CMP permet de retirer les portions des couches 65 et 63 situées sur la face avant de la structure. En d'autres termes, l'étape de CMP permet de découvrir la face supérieure de la couche 15 et des plots de reprise de contact 17.

La couche 65 est, par exemple en un alliage de cuivre et/ou en un alliage d'étain et/ou en un alliage d'argent ou en tout autre matériau adapté à être brasé. A titre d'exemple, la couche 65 est en un alliage d'étain et d'argent (SnAg).

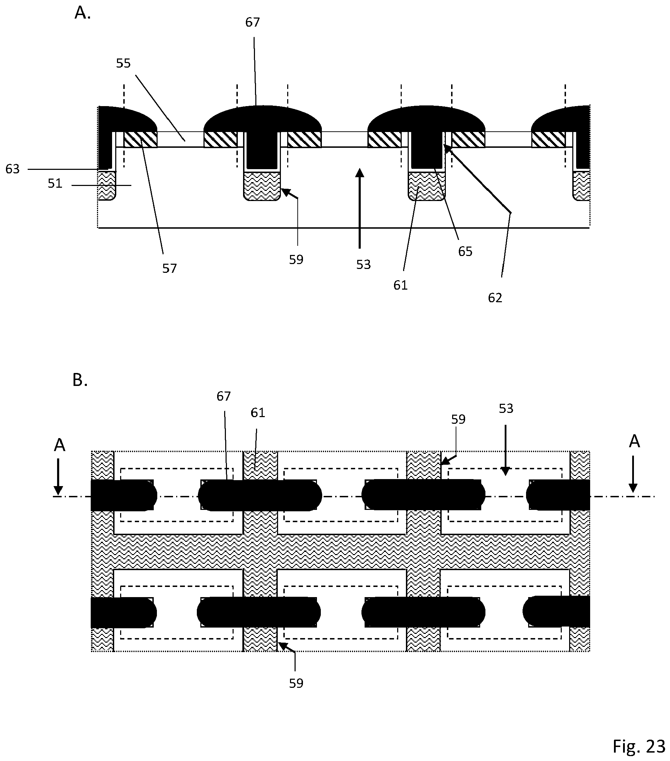

La figure 23 illustre, par une vue en coupe (A) et une vue de dessus (B), une étape e2) de formation de bossages 67 en un matériau métallique sur la face supérieure de la structure obtenue à l'issue des étapes des figures 16 à 22. La vue (A) est une vue en coupe selon le plan de coupe A-A de la vue (B).

Les bossages 67 sont, de préférence, en le même matériau que la couche 65. Toutefois, les matériaux des couches 67 et 65 peuvent être différents.

Chaque bossage 67 est, selon le mode de réalisation illustré en figure 23, réalisé de façon à recouvrir une unique ouverture 62 en se prolongeant de façon à recouvrir les plots de reprise de contact 57 voisins. En d'autres termes, chaque bossage 67 est réalisé de sorte qu'il connecte électriquement le matériau de la couche 65 situé dans l'ouverture 62 qu'il recouvre et les plots de reprise de contact 57 de deux circuits 53 séparés par cette même ouverture 62. Les plots de reprise de contact 57 recouverts par un même bossage 67 sont les plots de reprise de contact 57 situés en vis-à-vis de cette même ouverture 62. On notera que les bossages 67 n'ont, comme on le verra par la suite, pas vocation à former des interconnexions fonctionnelles entre deux puces voisines.

Les bossages 67 sont, selon un mode de mise en oeuvre, formés par sérigraphie ou par croissance électrolytique.

Les bossages 67 sont, selon un autre mode de mise en oeuvre, formés par dépôt métallique à travers un masque.

A titre d'exemple, les bossages 67 sont, comme cela a été représenté en vue (B), tous orientés dans la même direction.

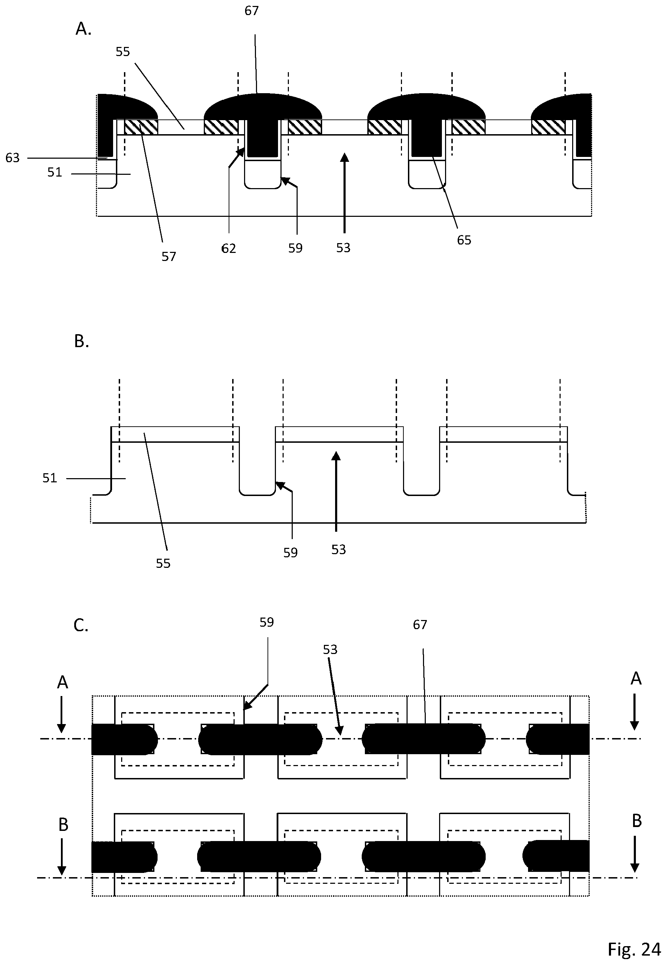

La figure 24 illustre, par deux vues en coupe (A) et (B) et une vue de dessus (C), une étape f2) de retrait de ce qui subsiste de la résine 61 de la structure obtenue à l'issue des étapes des figures 16 à 23.

La vue (A) est une vue en coupe selon le plan de coupe A-A de la vue (C) et la vue (B) est une vue en coupe selon le plan de coupe B-B de la vue (C).

Plus particulièrement, on vient, lors de cette étape, retirer ce qui subsiste de la résine de la couche 61 dans la structure obtenue à l'issue de l'étape de la figure 23, c'est-à-dire que la couche 61 est retirée dans les ouvertures 59 et dans les ouvertures 59 sous les bossages 67.

Cette étape de retrait est, par exemple, réalisée par gravure à l'aide d'un solvant solubilisant la résine de la couche 61.

A l'issue de cette étape, le fond des ouvertures 59 situées sous les bossages 67 est accessible par les parties des ouvertures 59 non recouvertes par les bossages. On notera que les bossages 67 forment, à l'issue de l'étape illustrée en figure 24, des sortes de "ponts" au dessus des ouvertures 59.

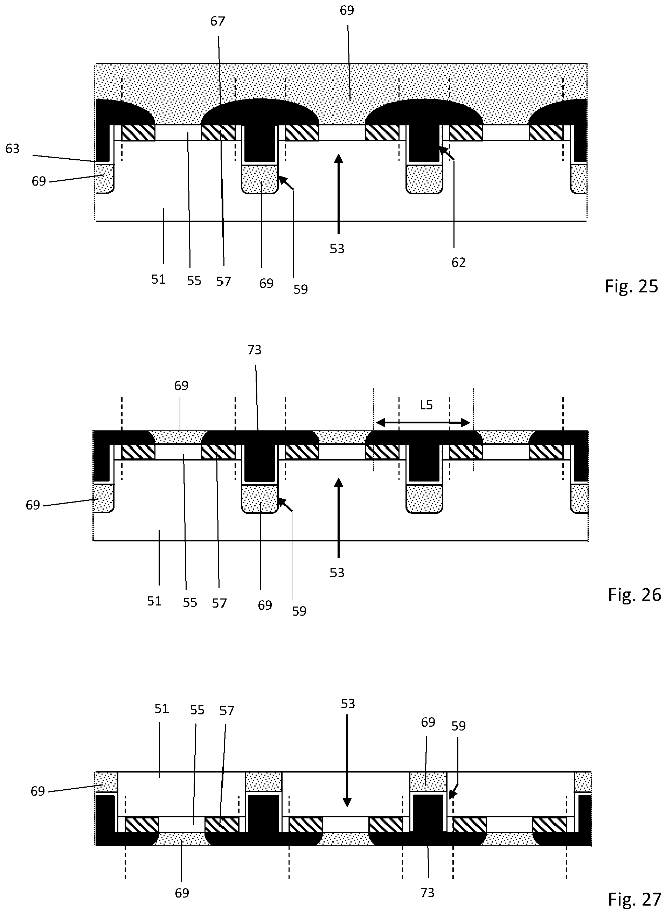

La figure 25 illustre, par une vues en coupe, une étape de dépôt d'une résine isolante de protection 69 différente de la résine 61 de la figure 23, à la surface de la structure obtenue à l'issue des étapes des figures 16 à 24.

La résine 61 désormais complémentent éliminée avait pour objet de définir les ouvertures 62 de formation des métallisations 65 tandis que la résine 69 a pour objet de subsister une fois le produit fini pour isoler électriquement le substrat 51.

Lors de l'étape illustrée en figure 25, on vient recouvrir intégralement la face supérieure de la structure obtenue à l'issue des étapes des figures 16 à 24, et en particulier recouvrir les bossages 67 et combler les ouvertures 59 sous les bossages 67 et autour du substrat 51 de chaque circuit intégré 53. La résine 69 est, par exemple, une résine époxy.

La figure 26 illustre par une vue en coupe une étape g2) de planarisation de la face supérieure de la structure obtenue à l'issue des étapes des figures 16 à 25. La planarisation est, par exemple, réalisée par CMP. Lors de cette étape, une partie supérieure de la résine de protection 69 est retirée. L'étape de planarisation se poursuit jusqu'à amincir ce qui subsiste des bossages 67 pour former les contacts métalliques 73. Ainsi, les contacts métalliques 73 affleurent à la surface de la face supérieure de ce qui subsiste de la couche de résine 69 entre ces contacts.

Plus particulièrement, la planarisation est effectuée jusqu'à découvrir les contacts métalliques 73 sur une longueur L5 (dans le plan de la puce) supérieure à 40 µm et sur une largeur supérieure à 100 µm. La longueur L5 est, par exemple, comprise entre 40 µm et 1400 µm, de préférence comprise entre 200 µm et 1000 µm. La largeur des contacts métalliques 73 est, par exemple à l'issue de l'étape de planarisation, comprise entre 100 µm et 600 µm, de préférence comprise entre 100 µm et 400 µm. Ces dimensions sont choisies en fonction de la largeur des ouvertures 59 et des dimensions des plots de reprise de contact 57.

La figure 27 illustre par une vue en coupe une étape h2) de planarisation de la face inférieure de la structure obtenue à l'issue des étapes des figures 16 à 26.

On notera que dans l'exemple de la figure 27, l'orientation de la structure est inversée par rapport aux vues en coupe des figures précédentes.

Le substrat 51 est aminci par sa face arrière (face supérieure en figure 27), par exemple par CMP. Dans cet exemple, le substrat 51 est aminci par sa face arrière jusqu'à atteindre au moins le fond des ouvertures 59, de sorte que, après amincissement, ce qui subsiste de la résine 69 présente dans les ouvertures 59 affleure à la surface de la face arrière du substrat 51. A l'issue de cette étape, les circuits intégrés 53 ne sont plus reliés entre eux que par ce qui subsiste de la couche 69 et, éventuellement, un film support, non représenté en figure 27, fixé sur la face supérieure de la structure.

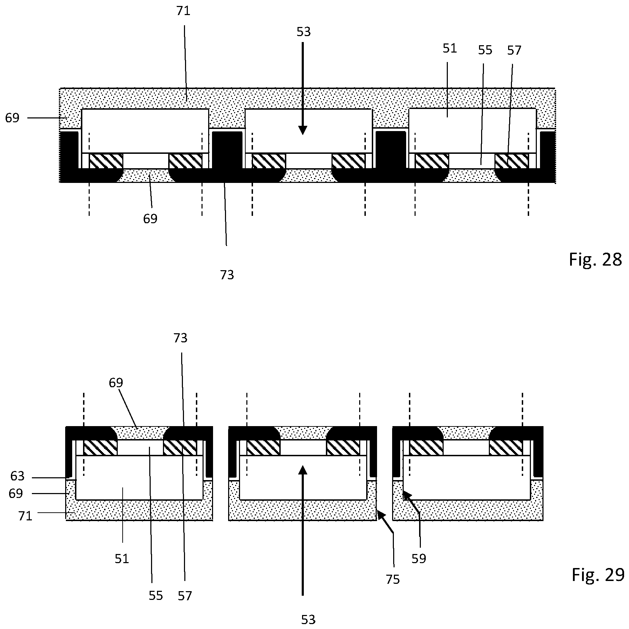

La figure 28 illustre par une vue en coupe une étape de dépôt d'une résine de protection 71 sur la face arrière de la face inférieure de la structure obtenue à l'issue des étapes des figures 16 à 27.

La couche 71 s'étend par exemple pleine plaque, de façon continue, et sur une épaisseur sensiblement constante sur toute la surface de la face arrière de la structure. La couche 71 a, par exemple, une épaisseur comprise entre 10 µm et une épaisseur selon la dimension finale du boitier. L'épaisseur de la couche 71 est, de préférence, comprise entre 10 µm et 100 µm, par exemple de l'ordre de 25 µm. Les résines des couches 71 et 69 peuvent être de même composition ou de compositions différentes.

La figure 29 illustre par une vue en coupe une étape i2) de formation de tranchées 75 à partir de la face avant de la structure obtenue à l'issue des étapes des figures 16 à 28.

Plus particulièrement, cette étape correspond à une étape de découpe de la structure en puces individuelles comprenant chacune un unique circuit intégré 53.

Selon le mode de réalisation illustré en figure 29, on vient former, au droit des ouvertures 59, des tranchées 75. Les tranchées 75 peuvent, par exemple, en vue de dessus, former une grille continue s'étendant entre les circuits intégrés 53. Les tranchées 75 s'étendent, verticalement, sur toute l'épaisseur de la structure et plus particulièrement dans les contacts métalliques 73 et les couches 69 et 71.

Les tranchées 75 sont, par exemple, réalisées par sciage.

Les tranchées 75 permettent ainsi de séparer les contacts métalliques 73 en deux portions, de préférence, identiques. Chacune des deux portions des contacts métalliques 31 correspond à un contact métallique 73 d'une puce. Les tranchées 75 permettent en outre de découvrir au moins un flanc de chaque contact métallique 73 de chaque puce.

La largeur des tranchées 75 est inférieure à celle des ouvertures 59 de sorte que, après formation des tranchées 75, chaque circuit intégré 53, et pas conséquent chaque puce 5, reste recouvert par de la résine 69 ou 71 sur toutes ses faces à l'exception des contacts métalliques 73 formant les flancs mouillables de la puce.

L'étape illustrée en figure 29 est, par exemple, précédée d'une étape de report de la structure obtenue à l'issue des étapes des figures 16 à 28, de préférence, par sa face arrière, sur un film support permettant aux puces d'être maintenues ensemble. Les puces peuvent ensuite être prélevées sur le film support.

A l'issue de cette étape, la structure obtenue correspond à une pluralité de puces électronique. Les flancs des contacts métalliques 73 exposés lors de cette étape correspondent à des flancs mouillables des puces.

Un avantage des modes de réalisation et des modes de mise en oeuvre décrits est qu'ils permettent d'intégrer la hauteur des contacts métalliques des puces à flancs mouillables dans l'épaisseur du substrat.

Un autre avantage des modes de réalisation et des modes de mise en oeuvre décrits est qu'ils permettent de diminuer l'épaisseur des puces électroniques à flancs mouillables et, par conséquent, l'épaisseur des circuits imprimés.

Un avantage des modes de réalisation et des mode de mise en oeuvre décrits en figures 16 à 29 est qu'ils permettent la fabrication de puces cubiques ou ayant la forme de pavés.

Un autre avantage des modes de réalisation et des modes de mise en oeuvre décrits en figures 16 à 29 est qu'ils permettent de s'affranchir d'une marche dans les flancs mouillable de la puce, ladite marche pouvant être une gène à l'inspection visuelle de la brasure lors du montage des puces sur un circuit imprimé.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnés ci-dessus.

Enfin, la mise en oeuvre pratique des modes de réalisation et variantes décrits est à la portée de la personne du métier à partir des indications fonctionnelles données ci-dessus.

## Revendications

1. Puce électronique (1 ; 5) comportant un substrat semi-conducteur (11 ; 51) portant au moins un contact métallique (31 ; 73) s'étendant, dans l'épaisseur du substrat, le long d'au moins un flanc de la puce.

2. Procédé de fabrication d'une puce électronique (1 ; 5) comportant au moins un étape de formation d'au moins un contact métallique (31 ; 73) s'étendant, dans l'épaisseur d'un substrat semi-conducteur (11 ; 51), le long d'au moins un flanc de la puce.

3. Puce selon la revendication 1 ou procédé selon la revendication 2, dans lequel le contact métallique (31 ; 73) affleure à une face supérieure de la puce (1 ; 5), ladite face étant plane.

4. Puce électronique selon la revendication 1 ou 3 ou procédé selon la revendication 2 ou 3, dans lequel la puce (1 ; 5) est uniquement recouverte du ou des contacts métalliques (31 ; 73) et d'une ou de résines de protection isolantes (33, 35 ; 69, 71).

5. Puce électronique selon la revendication 1, 3 ou 4 ou procédé selon l'une quelconque des revendications 2 à 4, dans lequel le contact métallique (31 ; 73) s'étend le long d'au moins un flanc de la puce (1 ; 5) sur une hauteur comprise entre 50 µm et 200 µm, de préférence de l'ordre de 100 µm.

6. Puce électronique selon l'une quelconque des revendications 1 et 3 à 5 ou procédé selon l'une quelconque des revendications 2 à 5, dans lequel les contacts métalliques (31 ; 73) sont en un alliage à base d'étain.

7. Puce électronique selon l'une quelconque des revendications 1 et 3 à 6 ou procédé selon l'une quelconque des revendications 2 à 6, dans lequel une face inférieure du substrat (11 ; 51) est recouverte d'une résine de protection isolante électriquement (35 ; 71).

8. Puce électronique selon l'une quelconque des revendications 1 et 3 à 7 ou procédé selon l'une quelconque des revendications 2 à 7, dans lequel le contact métallique (31 ; 73) est, dans l'épaisseur du substrat (11 ; 51), séparé du substrat par une couche d'isolation (21 ; 63).

9. Puce électronique selon l'une quelconque des revendications 1 et 3 à 8 ou procédé selon l'une quelconque des revendications 2 à 8, dans lequel la puce (1) a la forme d'un parallélépipède comprenant, au moins au niveau des contacts métalliques, un épaulement dans la hauteur de la puce.

10. Puce électronique ou procédé selon la revendication 9, dans lequel le contact métallique (31 ; 73) s'étend en continu sur au moins une partie d'une face supérieure de la puce (1 ; 5), sur au moins une partie d'une face latérale de la puce et sur au moins une partie d'une face de l'épaulement, parallèle à la face supérieure.

11. Procédé selon la revendication 9 ou 10, comprenant au moins les étapes suivantes :
a1) former, du coté d'une face supérieure du substrat (11) semi-conducteur, dans et sur lequel ont été préalablement formés une pluralité de circuits intégrés (13), des premières ouvertures (19) séparant latéralement des circuits intégrés (13) ;
b1) déposer, dans les premières ouvertures (19) et sur une partie de la face supérieure du substrat (11), une couche (23) en un matériau métallique ;
c1) former, à l'aplomb de la couche métallique (23), des bossages (25), les bossages recouvrant la couche métallique (23) et au moins deux plots de reprise de contact métalliques (17) de deux circuits intégrés (13) voisins formés dans le même substrat (11) ;
d1) former, à partir de la face supérieure du substrat (11), des premières tranchées (29) de façon à individualiser chaque circuit intégré (13), les premières tranchées (29) coupant les bossages (25) et s'étendant sur une largeur inférieure ou égale à la largeur des premières ouvertures (19) et sur une profondeur supérieure à la profondeur des premières ouvertures (19) ;
e1) déposer, dans les premières tranchées (29) et sur l'ensemble de la face supérieure du substrat une résine de protection isolante électriquement (33) ;
f1) amincir le substrat (11) par sa face supérieure de façon à retirer une partie de la résine de protection isolante (33) et une partie des bossages (25) ;
g1) amincir le substrat (11) par sa face inférieure jusqu'à atteindre la résine de protection isolante (33) située au fond des premières tranchées (29) ;
h1) former, à partir de la face supérieure du substrat (11), des deuxièmes ouvertures (37) à l'aplomb des premières ouvertures (19) ; et
i1) découper la résine de protection (33) à l'aplomb des premières tranchées (29), de façon à séparer les circuits intégrés (13) en puces individuelles (1) avec une largeur inférieure à la largeur des premières tranchées (29).

12. Procédé selon la revendication 11 dans lequel, à l'étape h1), ce qui subsiste des bossages (25) et de la couche métallique (23) est coupé par les deuxièmes ouvertures (37) de façon à former les contacts métalliques (31) .

13. Procédé selon la revendication 11 ou 12, dans lequel, lors de l'étape b1) la couche métallique (23) est moulée dans les premières ouvertures (19).

14. Procédé selon l'une quelconque des revendications 11 à 13, dans lequel le remplissage des premières ouvertures par la couche métallique à l'étape b1) est réalisé par un procédé de dépôt par électroplacage.

15. Procédé selon l'une quelconque des revendications 11 à 14, dans lequel les premières ouvertures (19) et les deuxièmes ouvertures (37) sont réalisées par ablation laser ou par sciage.

16. Puce électronique selon l'une quelconque des revendications 1 et 3 à 8 ou procédé selon l'une quelconque des revendications 2 à 8, dans laquelle la puce (5) comprend six faces planes organisées en un parallélépipède, la puce comprenant au moins un contact métallique (73) formant un angle entre deux faces consécutives du parallélépipède, le contact (73) s'étendant sur une partie de l'épaisseur du substrat (51).

17. Procédé selon la revendication 16, comprenant les étapes suivantes :
a2) former, du coté d'une face supérieure du substrat (51) semi-conducteur, dans et sur lequel ont été préalablement formés une pluralité de circuits intégrés (53), des premières ouvertures (59) séparant latéralement des circuits intégrés (53) ;
b2) déposer, dans les premières ouvertures (59), une couche en une résine photosensible (61) ;
c2) former des deuxièmes ouvertures (62) localement dans la couche de résine photosensible (61) dans les premières ouvertures (59) sur une partie seulement de l'épaisseur de la couche de résine photosensible (61) ;
d2) déposer, dans les deuxièmes ouvertures (62), une couche en un matériau métallique (65) ;
e2) former, à l'aplomb de la couche métallique (65), des bossages (67), les bossages (67) recouvrant la couche métallique (65) et au moins deux plots de reprise de contact (57) de deux circuits intégrés (53) voisins formés dans le même substrat (51) ;
f2) retirer la couche de résine photosensible (61) dans l'ensemble de la structure et remplir les espaces laissés libres par une couche d'une résine de protection isolante (69) ;
g2) amincir le substrat (51) par sa face supérieure de façon à retirer une partie de la couche de résine de protection isolante (69) et une partie des bossages (67) de façon à former les contacts métalliques (73) ;
h2) amincir le substrat (5) par sa face inférieure jusqu'à atteindre résine de protection isolante (69) au fond des premières ouvertures (59) ; et
i2) déposer sur la face inférieure du substrat une autre couche de résine de protection isolante (71) et découper la résine de protection isolante (69) et les contacts métalliques (73) en vis-à-vis des premières ouvertures (59) avec une largeur inférieure à la largeur des premières ouvertures (59), de façon à séparer les circuits intégrés (53) en puces individuelles (5) et à dégager un flanc d'au moins un contact métallique (73) de chaque circuit intégré (53) .

18. Procédé selon la revendication 17, dans lequel la découpe à l'étape i2) est réalisée par sciage.

19. Procédé selon la revendication 17 ou 18, dans lequel les premières ouvertures (59) sont réalisées par ablation laser ou par sciage.

20. Procédé selon l'une quelconque des revendications 17 à 19, dans lequel les deuxièmes ouvertures (62) sont réalisées par photolithogravure ou par ablation laser.
